# EUROPÄISCHE PATENTSCHRIFT

(11) **EP 1 734 156 B1**
(45) Veröffentlichungstag und Bekanntmachung des Hinweises auf die Patenterteilung: **01.03.2017**
(21) Anmeldenummer: 06011977.3
(22) Anmeldetag: 09.06.2006
(51) Int. Cl.: C25D 5/54, C23C 18/16, C23C 18/31, C23C 18/20, H05K 3/18, C23C 18/30, C23C 18/28

(54) **Verfahren zur Direktmetallisierung von nicht leitenden Substraten**
Process for the direct metallization of nonconductive substrates
Procédé de métallisation directe des substrat non-conductive

(30) Priorität: 10.06.2005 DE 102005027123
(43) Veröffentlichungstag der Anmeldung: 20.12.2006
(73) Patentinhaber: Enthone, Inc., West Haven, CT 06516 (US)
(72) Erfinder: Königshofen, Andreas, 51371 Leverkusen (DE); Möbius, Andreas, 41564 Kaarst (DE)
(74) Vertreter: Michalski Hüttermann & Partner Patentanwälte mbB

(56) Entgegenhaltungen:
- EP-A- 1 600 528
- EP-A1- 0 616 053
- DE-A1- 3 248 000
- US-A- 3 619 243
- US-A- 4 814 205

## Beschreibung

Die vorliegenden Erfindung betrifft ein Verfahren zur Direktmetallisierung von nicht leitenden Substraten.

Aus dem Stand der Technik sind unterschiedliche Verfahren zur Direktmetallisierung von nicht leitenden Substraten wie beispielsweise Platinen für gedruckte Schaltkreise oder Kunststoffformteile bekannt.

So offenbart beispielsweise die europäische Patentanmeldung EP 0 538 006 ein Verfahren zur Direktmetallisierung, bei welchem das Substrat mit einer Aktivatorlösung, aufweisend ein Palladium-Zinn-Kolloid, aktiviert wird und im Anschluss an die Aktivierung mit einer Post-Aktivatorlösung kontaktiert, wird, welche eine hinreichende Menge von Ionen enthält, die unter den Reaktionsbedingungen eine Disproportionierungsreaktion eingehen. Das so behandelte Substrat wird anschließend mit einer sauren Lösung behandelt.

Das europäische Patent EP 0 616 053 offenbart ein identisches Verfahren, wobei jedoch die Metallzusammensetzung das abzuscheidende Metall in Form der höchsten Oxidationsstufe enthält.

Den aus dem Stand der Technik bekannten Verfahren ist gemeinsam, dass es bei deren großtechnische Anwendung zu Problemen wie Verkrustungen durch Salzablagerungen an den Anlagenbauteilen kommt. Dies führt zu mangelhaften Beschichtungsergebnissen, so dass die nach dem Stand der Technik betriebenen Anlagen in regelmäßigen Abständen gereinigt und von Verkrustungen befreit werden müssen.

Bei dem aus dem Stand der Technik bekannten Verfahren bilden sich nach einigen Stunde an Heizelementen und Behälterwänden schwerlösliche Lithiumcarbonatausfällungen, da Kohlendioxid aus der Luft in die alkalische Lösung eingetragen und dort als Carbonat gelöst wird. Die Lithiumcarbonatausfällungen beeinträchtigen den Prozessablauf negativ, da abbröckelnde Partikel zu Rauigkeiten und dadurch zu erhöhten Ausschussraten führen und die Heizleistung durch die Verkrustung der Heizelemente so stark herabgesetzt wird, dass sich zum einen der Stromverbrauch erhöht und zum anderen die Arbeitstemperatur nur durch zusätzliche Heizelemente aufrecht erhalten werden kann.

Der Erfindung liegt die **Aufgabe** zugrunde, ein verbessertes Verfahren zur Direktmetallisierung bereitzustellen, welches die aus dem Stand der Technik bekannten Probleme, insbesondere die durch Verkrustung auftretenden Probleme, zu überwinden vermag.

**Gelöst** wird diese Aufgabe durch ein Verfahren zur Metallisierung eines nicht leitenden Substrats gemäß Anspruch 1.

Vorteilhafterweise werden die nicht leitenden Substrate vor der Behandlung mit der metallhaltigen Aktivatorlösung vorbehandelt. Eine solche Vorbehandlung kann beispielsweise einen Beizschritt einschließen.

Die metallhaltige Aktivatorlösung besteht vorteilhafterweise aus einer Lösung eines Metall/Metall-Kolloids mit einem ersten Kemmetall und einem zweiten, den Kern kolloidal umgebenden Kolloidmetall. Das Kemmetall ist vorteilhafterweise wenigstens ein Metall der Gruppe bestehend aus Silber, Gold, Platin oder Palladium. Das Kolloidmetall ist vorteilhafterweise wenigstens ein Metall der Gruppe bestehend aus Eisen, Zinn, Blei, Kobalt oder Germanium.

Weitere aus dem Stand der Technik bekannte Aktivatorlösungen sind gleichfalls im erfindungsgemäßen Verfahren einsetzbar.

Im Anschluss an die Behandlung mit der Aktivatorlösung folgt das Kontaktieren des behandelten Substrats mit einer Metallsalzlösung, aufweisend wenigstens ein durch ein Metall der Aktivatorlösung reduzierbares Metall, einen Komplexbildner sowie wenigstens ein Metall der Gruppe bestehend aus Lithium, Kalium, Rubidium und Cäsium.

Vorteilhafterweise wirkt als reduzierendes Metall der metallhaltigen Aktivatorlösung das Kolloidmetall des Metall/Metallkolloids. Als durch das Kolloidmetall reduzierbares Metall kann jedes Metall eingesetzt werden, welches ein entsprechend höheres Standard-Elektrodenpotential besitzt und sich somit durch das Kolloidmetall reduzieren läßt. Insbesondere geeignet sind Kupfer, Silber, Gold, Nickel, Palladium, Platin, Bismuth oder Mischungen dieser.

Als Komplexbildner wird vorteilhafterweise ein Komplexbildner in einer Menge eingesetzt, die ausreichend ist, um ein Ausfallen von schwer löslichen Salzen der durch die Kolloidmetalle reduzierbaren Metalle zu verhindern.

Geeignete Komplexbildner sind beispielsweise Monoethanolamin, EDTA, Weinsäure, Milchsäure, Zitronensäure, Oxalsäure, Salicylsäure, deren Salze oder Derivate sowie Mischungen dieser.

Vorteilhafterweise weist die Metallsalzlösung einen alkalischen pH-Wert zwischen pH 11,5 und pH 13,5 und bevorzugt zwischen pH 12,5 und pH 13,5 auf. Zur Einstellung des pH-Wertes können der Metallsalzlösung entsprechende Hydroxide, andere Alkalisierungsmittel und/oder Puffersubstanzen zugegeben werden.

Die Kontaktierung des mit der Aktivatorlösung behandelten Substrates erfolgt vorteilhafterweise bei einer Temperatur zwischen 20 und 90° C, bevorzugt zwischen 30 und 80° C, besonders bevorzugt zwischen 40 und 75° C.

Durch die Behandlung des Substrates mit der erfindungsgemäßen Metallsalzlösung kommt es zur stromlosen Abscheidung leitfähiger Strukturen auf der Substratoberfläche. Hierdurch ist ein anschließendes stromloses oder auch galvanischen Beschichten des behandelten Substrates mit einem Metall, wie z. B. das Verkupfern oder das Vernickeln, möglich.

Neben dem erfindungsgemäßen Verfahren betrifft die Erfindung auch eine verfahrensgemäß einsetzbare Metallsalzlösung zur stromlosen Abscheidung von Metallen in der zuvor beschriebenen Art und Weise.

Durch das erfindungsgemäße Verfahren sowie die erfindungsgemäße Metallsalzlösung wird die Bildung von schwer löslichen Salzen der im Verfahren befindlichen Metallionen zumindest teilweise unterdrückt. Hierdurch sind deutlich längere Betriebszeiten und deutlich kürzere Totzeiten durch Wartung, insbesondere Entkrustung der Anlagen, möglich.

Die nachfolgenden Beispiele zeigen Ausführungsformen des erfindungsgemäßen Verfahrens, auf welche sich die Erfindung jedoch nicht beschränken lässt.

### Beispiel 1

Ein ABS-Werkstück wird kontaktiert und in einer Chromschwefelsäure aufgeraut. Anschließend wird das Werkstück gespült und in einer kolloidalen Aktivatorlösung, bestehend aus 200 mg/l Palladium, 30 g/l Zinn(II)chlorid und 300 ml/l konzentrierter Salzsäure, konditioniert. Nach nochmaligem Spülen wird das Werkstück in einer nachfolgend beschriebenen Metallsalzlösung getaucht, so dass auf der nicht leitenden Kunststoffoberfläche eine dünne leitfähige Schicht erzeugt wird:
1,0 mol/l Natriumhydroxid
0,5 mol/l Lithiumchlorid
0,4 mol/l Kalium-Natrium-Tartrat
0,015 mol/l Kupfersulfat

Das Werkstück wird wiederum gespült und anschließend durch Anlegen einer Spannung in einem sauren Glanzkupferelektrolyten metallisiert. Auf diese Weise wird eine funktionell und dekorativ einwandfreie Metallbeschichtung des ABS-Werkstoffes erzeugt.

### Beispiel 2

Ein ABS-Werkstück wird kontaktiert und in einer Chromschwefelsäure aufgeraut. Anschließend wird das Werkstück gespült und in einer kolloidalen Aktivatorlösung, bestehend aus 200 mg/l Palladium, 30 g/l Zinn(II)chlorid und 300 ml/l konzentrierter Salzsäure, konditioniert. Nach nochmaligem Spülen wird das Werkstück in einer nachfolgend beschriebenen Metallsalzlösung getaucht, so dass auf der nicht leitenden Kunststoffoberfläche eine dünne leitfähige Schicht erzeugt wird:
0,5 mol/l Natriumhydroxid
0,5 mol/l Lithiumhydroxid
0,5 mol/l Kaliumbromid
0,4 mol/l Kalium-Natrium-Tartrat
0,015 mol/l Kupfersulfat.

Das Werkstück wird wiederum gespült und anschließend durch Anlegen einer Spannung in einem sauren Glanzkupferelektrolyten metallisiert. Auf diese Weise wird eine funktionell und dekorativ einwandfreie Metallbeschichtung des ABS-Werkstoffes erzeugt.

Die aus dem Stand der Technik bekannten Probleme durch Ausfällungen werden mit dem erfindungsgemäßen Verfahren vermieden oder zumindest deutlich verringert. Erst nach Monaten zeigten sich bei Anwendung des erfindungsgemäßen Verfahrens leichte Verkrustungen an Anlagenbauteile wie z. B. Heizelementen. Auf regelmäßige Beseitigung der Verkrustungen in kurzen Intervallen konnte verzichtet werden, wodurch sich Totzeiten auf ein Minimum beschränken ließen.

## Patentansprüche

1. Verfahren zum Metallisieren eines nicht leitenden Substrates aufweisend wenigstens die Verfahrensschritte:
Kontaktieren des Substrates mit einer metallhaltigen Aktivatorlösung.
Kontaktieren des mit der Aktivatorlösung kontaktierten Substrates mit einer Metallsalzlösung, aufweisend wenigstens ein durch ein Metall der Aktivatorlösung reduzierbares Metall, einen Komplexbildner sowie wenigstens ein Metall aus der Gruppe bestehend aus Lithium, Kalium, Rubidium oder Cäsium,
anschließendes stromloses oder galvanisches Beschichten des behandelten Substrates mit einem Metall,
**dadurch gekennzeichnet, dass**
der Metallsalzlösung zur Einstellung eines alkalischen pH-Wertes zwischen pH 10 und pH 14 entsprechende Hydroxide, andere Alkalisierungsmittel und/oder Puffersubstanzen zugegeben wird, und das Metall der Gruppe bestehend aus Lithium, Kalium, Rubidium oder Cäsium als Salz der Gruppe bestehend aus Fluoriden, Chloriden, Iodiden, Bromiden, Nitraten, Sulfaten oder Mischungen dieser aufweist.

2. Verfahren gemäß Anspruch 1, **dadurch gekennzeichnet, dass** die metallhaltige Aktivatorlösung ein Metall/Metall-Kolloid mit einem ersten Kernmetall und einem zweiten, den Kern kolloidal umgebenden Kolloidmetall aufweist, wobei das Kernmetall ausgewählt ist aus der Gruppe bestehend aus Silber, Gold, Platin oder Palladium und das Kolloidmetall ausgewählt ist aus der Gruppe bestehend aus Eisen, Zinn, Blei, Cobalt oder Germanium.

3. Verfahren nach einem der vorhergehenden Ansprüche, **dadurch gekennzeichnet, dass** die Metallsalzlösung als Komplexbildner eine Verbindung der Gruppe bestehend aus Monoethanolamin, EDTA, Weinsäure, Milchsäure, Zitronensäure, Oxalsäure, Salicylsäure, deren Salze oder Derivate sowie Mischungen dieser aufweist.

4. Verfahren nach einem der vorhergehenden Ansprüche, **dadurch gekennzeichnet, dass** der Metallsalzlösung zur Einstellung eines alkalischen pH-Wertes zwischen pH 11,5 und pH 13,5 und bevorzugt zwischen 12,5 und 13,5 entsprechende Hydroxide, andere Alkalisierungsmittel und/oder Puffersubstanzen zugegeben werden.

5. Verfahren gemäß einem der vorhergehenden Ansprüche, **dadurch gekennzeichnet, dass** das Substrat mit der Metallsalzlösung bei einer Temperatur zwischen 20 und 90° C, bevorzugt zwischen 30 und 80° C, besonders bevorzugt zwischen 40 und 75° C kontaktiert wird.

## Claims

1. Method for metallizing a nonconducting substrate comprising at least the method steps:
contacting the substrate with a metal containing activator solution;
contacting the substrate contacted with the activator solution with a metal salt solution comprising at least one metal which is adapted to be reduced by a metal of the activator solution, a complexing agent and at least one metal of the group consisting of lithium, potassium, rubidium or cesium; and
subsequently electroless or galvanically coating the treated substrate with a metal;
**characterized in that**
for adjusting an alkaline pH-value between pH 10 and pH 14 corresponding hydroxides or other alkalization agents and/or buffer substances are added to the metal salt solution and the metal salt solution comprises the metal of the group consisting of lithium, potassium, rubidium or cesium in the form of a salt of the group consisting of fluorides, chlorides, iodides, bromides, nitrates, sulfates or mixtures thereof.

2. Method according to claim 1, **characterized in that** the metal containing activator solution comprises a metal/metal colloid comprising a first core metal and a second colloid metal colloidally surrounding the core, wherein the core metal is selected from the group consisting of silver, gold, platinum or palladium and the colloid metal is selected from the group consisting of iron, tin, lead, cobalt or germanium.

3. Method according to any one of the preceding claims, **characterized in that** the metal salt solution as a complexing agent comprises a compound of the group consisting of monoethanolamine, EDTA, tartaric acid, lactic acid, citric acid, oxalic acid, salicylic acid, salts, derivatives and mixtures thereof.

4. Method according to any one of the preceding claims, **characterized in that** for adjusting an alkaline pH-value between pH 11.5 and pH 13.5 and preferably between 12.5 and 13.5 corresponding hydroxides, other alkalization agents and/or buffer substances are added to the metal salt solution.

5. Method according to any one of the preceding claims, **characterized in that** the substrate is contacted with the metal salt solution at a temperature between 20°C and 90°C, preferably between 30°C and 80°C, particularly preferably between 40°C and 75°C.

## Revendications

1. Procédé de métallisation d'un substrat non conducteur comprenant au moins les étapes de procédé :
mise en contact du substrat avec une solution d'activateur contenant un métal,
mise en contact du substrat mis en contact avec la solution d'activateur avec une solution d'un sel métallique, présentant au moins un métal pouvant être réduit par un métal de la solution d'activateur, un agent de complexation ainsi qu'au moins un métal provenant du groupe constitué du lithium, du potassium, du rubidium ou du césium,
puis, revêtement sans courant électrique ou galvanique du substrat traité avec un métal,
**caractérisé en ce que**
pour le réglage d'une valeur de pH alcalin entre pH 10 et pH 14, à la solution de sel métallique, des hydroxydes correspondants, d'autres produits d'alcalinisation et/ou des produits tampons sont ajoutés, et que le métal du groupe constitué du lithium, du potassium, du rubidium ou du césium se présente sous la forme d'un sel du groupe constitué des fluorures, des chlorures, des iodures, des bromures, des nitrates, des sulfates ou de mélange de ceux-ci.

2. Procédé selon la revendication 1, **caractérisé en ce que** la solution d'activateur contenant un métal présente un colloïde métal/métal avec un premier métal de coeur et un second métal colloïde entourant le coeur de manière colloïdale, où le métal de coeur est choisi dans le groupe constitué de l'argent, de l'or, du platine ou du palladium et le métal colloïde est choisi dans le groupe constitué du fer, de l'étain, du plomb, du cobalt ou du germanium.

3. Procédé selon l'une des revendications précédentes, **caractérisé en ce que** la solution de sel de métal présente, en tant qu'agent de complexation, un composé du groupe constitué de la monoéthanolamine, de l'EDTA, de l'acide tartrique, de l'acide lactique, de l'acide citrique, de l'acide oxalique, de l'acide salicylique, de leurs sels ou dérivés ainsi que de mélanges de ceux-ci.

4. Procédé selon l'une des revendications précédentes, **caractérisé en ce qu'**à la solution de sel métallique, pour le réglage d'une valeur de pH alcalin entre pH 11,5 et pH 13,5, et de préférence entre 12,5 et 13,5, des hydroxydes appropriés, d'autres produits d'alcalinisation et/ou des produits tampons sont ajoutés.

5. Procédé selon l'une des revendications précédentes, **caractérisé en ce que** le substrat est mis en contact avec la solution de sel métallique à une température entre 20 et 90 °C, de préférence entre 30 et 80 °C, de manière particulièrement préférée entre 40 et 75 °C.
